# FASCICULE DE BREVET EUROPEEN

(11) **EP 3 390 691 B1**
(45) Date de publication et mention de la délivrance du brevet: **09.02.2022**
(21) Numéro de dépôt: 16826098.2
(22) Date de dépôt: 14.12.2016
(51) Int. Cl.: C23C 24/08, C23C 18/14

(54) **PROCÉDÉ DE FABRICATION D'UNE PIÈCE OU D'UNE MICROSTRUCTURE SUPPORTÉE PAR INSOLATION LASER D'UNE COUCHE D'UN OXALATE DE MÉTAL**
VERFAHREN ZUR HERSTELLUNG EINES BAUTEILS ODER EINER GETRÄGERTEN MIKROSTRUKTUR DURCH LASERBELICHTUNG EINER METALLOXALATSCHICHT
METHOD FOR MANUFACTURING A PART OR A SUPPORTED MICROSTRUCTURE BY LASER EXPOSURE OF A METAL OXALATE LAYER

(30) Priorité: 17.12.2015 FR 1562694
(43) Date de publication de la demande: 24.10.2018
(73) Titulaire: Université Toulouse III-Paul Sabatier, 31062 Toulouse Cedex 9 (FR); Centre National de la Recherche Scientifique, 75016 Paris (FR)
(72) Inventeur: BACO, Valérie, 31860 Labarthe Sur Leze (FR); TAILHADES, Philippe, 31650 Saint-orens (FR); LE TRONG, Hoa, 31520 Ramonville Saint Agne (FR); PASQUET, Isabelle, 31500 Toulouse (FR); CALMON, Pierre-François, 31450 Odars (FR); CAMON, Henri, 31320 Rebigue (FR); CONEDERA, Véronique, 31300 Toulouse (FR)
(74) Mandataire: Ipsilon
(86) Numéro de dépôt international: PCT/FR2016/053433
(87) Numéro de publication internationale: WO 2017/103482

(56) Documents cités:
- EP-A1- 2 540 437
- WO-A2-03/032084
- US-A1- 2009 291 230
- US-A1- 2010 209 698

## Description

L'invention concerne un procédé de fabrication d'une pièce métallique, céramique ou composite ou d'une microstructure métallique, céramique ou composite supportée, par insolation laser à partir d'oxalates de métaux.

Les couches de métaux et/ou d'oxydes de métaux transparents conducteurs tels que l'ITO (Oxyde d'étain-indium) ont trouvé un large champ d'applications comme enrobage transparent conducteur pour les écrans à cristaux liquides, les dispositifs d'écrans plats, les écrans à plasma, les écrans tactiles, ainsi que pour des applications liées aux encres électroniques, des diodes électroluminescentes organiques, des cellules photovoltaïques, des dépôts antistatiques et de blindage contre les interférences électromagnétiques. Les méthodes de dépôt de couches minces d'ITO sur un substrat comprennent : la pulvérisation cathodique, l'évaporation thermique, le dépôt assisté par laser pulsé (PLD), le dépôt chimique en phase vapeur, et la méthode sol-gel. Toutefois, ces méthodes exigent des équipements sophistiqués et/ou coûteux de par le vide très poussé et/ou la température élevée qu'elles nécessitent. D'autre part, les méthodes précitées ne permettent pas de former des microstructures et/ou des motifs complexes sur un substrat.

Par ailleurs, le brevet US 5,281,447 décrit une méthode de préparation d'une structure métallique supportée, par application d'un oxalate sur un substrat, et exposition dudit oxalate à une source d'énergie, ledit oxalate répondant à la formule suivante : 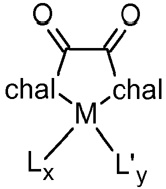 dans laquelle M est un métal du groupe VIII tel que Ni, Pt, Os, Rh, Ru, Ir ou Pd, chal est un atome d'oxygène, de soufre, de sélénium ou de tellure, Lₓ et L'_{y}, identiques ou différents, sont des ligands à base de soufre ou d'un des éléments du groupe VA (i.e. azote, phosphore, arsenic, antimoine ou bismuth), et x et y sont égaux à 0 ou 1. La structure métallique est réalisée à l'aide d'un masque ou en utilisant un faisceau d'énergie qui permet de tracer ladite structure selon le motif souhaité. En particulier, une solution d'un complexe d'oxalate de palladium répondant à la formule Pd(II)(oxalate)(CH₃CN)₂ dissous dans du méthanol est déposée sur un substrat non métallique et séchée afin de former un film sur ledit substrat. Puis, le film est exposé à un faisceau d'électrons ou à une lampe à arc Xe-Hg sans filtre, et rincé avec un solvant afin de former une structure de palladium métal sur ledit substrat. La présence des ligands Lₓ et L'_{y} est décrite comme primordiale pour stabiliser certains des complexes utilisés tels que l'oxalate de palladium(II) sous forme solide ou en solution, à l'égard de la décomposition spontanée. Cependant, la présence desdits ligands Lₓ et L'_{y} n'est pas suffisante pour stabiliser certains complexes tels que le bis(phosphine) oxalate de nickel. De plus, les conditions de préparation et d'exposition du film d'oxalate à une source d'énergie ne sont pas optimisées pour fabriquer des formes complexes, des motifs et/ou des microstructures présentant une bonne définition. En effet, l'utilisation d'une solution de l'oxalate peut induire une cristallisation non contrôlée de l'oxalate sous la forme de grosses particules et/ou de particules de tailles hétérogènes. De plus, la présence de ligands azotés tels que (CH₃CN)₂ pourrait conduire après l'exposition à une source d'énergie à la formation de phases indésirables. Enfin, les sources d'énergie utilisées ne sont pas focalisées.

Des méthodes alternatives telles que la sérigraphie (« *screen printing* »), l'électronique imprimée ou la lithographie sont étudiées pour fabriquer des microstructures sur un substrat, notamment dans le domaine de la microélectronique. Toutefois, elles ne permettent pas de former des motifs complexes tout en garantissant un dépôt structuré et continu. Elles ne permettent pas non plus d'utiliser des substrats courbes.

Les pièces macroscopiques ou 3D peuvent être réalisées par des procédés qualifiés de « fabrication additive ». Ces procédés permettent de s'affranchir des contraintes de conception liées à la mise en œuvre de techniques d'usinage traditionnelles, qui procèdent par enlèvement de matière et que l'on peut en conséquence qualifier de « soustractives ». Ils autorisent donc la réalisation de pièces originales dotées de caractéristiques esthétiques séduisantes ou de formes complexes assurant de manière optimale les propriétés mécaniques, électriques et/ou magnétiques souhaitées. Parmi les procédés de fabrication additive les plus utilisés à l'échelle industrielle, on distingue l'impression 3D ou procédé de projection de liant (« *Three Dimensional Printing* », 3DP), le dépôt de filament extrudé en fusion (« *Fused Deposition Modeling* », FDM), la densification par laser d'une poudre plastique, céramique, métallique ou de l'un de leurs mélanges (« *Selective Laser Sintering* », SLS ou « *Selective Laser Melting* », SLM), et la polymérisation d'une résine liquide photosensible (Stéréolithographie/SL). Afin de répondre à une demande de plus en plus importante de prototypes et de pièces fonctionnelles, les procédés laser (SL, SLM et SLS) ont atteint un degré de développement industriel important et indispensable dans beaucoup de domaines d'applications. En particulier, les méthodes SLS et SLM consistent à fritter ou fondre localement un lit de poudre de manière à dessiner en son sein, le plan de coupe d'une pièce. En superposant successivement de nouveaux lits de poudre au premier et en dessinant à chaque fois par le laser, le plan de coupe supérieur, on peut ainsi former une pièce en trois dimensions. La tenue mécanique de celle-ci est obtenue par le frittage ou la fusion - solidification des grains, à l'intérieur et à l'interface des couches de poudre superposées. En fin d'opération, la poudre qui n'a pas été insolée par le laser est éliminée pour libérer la pièce formée et la rendre fonctionnelle. Les méthodes SLS et SLM mettent généralement en œuvre des poudres dont la composition chimique est très proche, voire identique, à celle du matériau constitutif de la pièce finale. On peut par exemple citer comme matériaux dédiés à la fabrication par fusion directe du métal (SLM) et disponibles sur le marché : l'acier inoxydable 316L, le Cobalt Chrome, l'Inconel 625 (alliage à base de nickel et allié avec du chrome et du fer) et les alliages de titane (TiAl₆V₄). Néanmoins, le développement des méthodes SLM et SLS est limité par un choix restreint des matériaux utilisables pour fabriquer des pièces métalliques ou composites. En effet, le matériau doit posséder une absorption optique suffisante à la longueur d'onde du laser utilisé. Dans le cas contraire, le faisceau peut ne pas chauffer suffisamment les grains de poudres pour entraîner leur frittage ou leur fusion. La pièce finale ne présentera donc pas les caractéristiques mécaniques souhaitées ou le niveau de compacité visé. Ce problème peut, dans certains cas, être résolu soit par la mise en œuvre de lasers plus puissants, induisant une augmentation du coût de production de la pièce, soit en changeant la longueur d'onde du laser, ce qui peut également être à l'origine de différents problèmes techniques et économiques. Les procédés SLS et SLM peuvent même être inopérants avec des poudres de matériaux réfractaires, lorsque celles-ci possèdent de faibles absorptions optiques.

D'autres difficultés peuvent également être rencontrées telles qu'une tenue mécanique insuffisante et/ou la présence de discontinuités dans la pièce fabriquée. Par exemple, la fabrication additive à partir de poudres de céramique conduit généralement à des pièces poreuses, qui ne présentent pas la tenue mécanique attendue.

Enfin la demande de brevet européen EP 2 540 437 A1 décrit un procédé de fabrication d'un dispositif comprenant des brasures réalisées à partir de suspensions d'oxalates métalliques déposées entre deux surfaces des pièces à joindre.

Il existe donc un besoin en procédés permettant de fabriquer des pièces métalliques ou composites de façon simple et moins coûteuse et/ou mettant en œuvre des matériaux plus faciles à transformer.

Ainsi, le but de la présente invention est de pallier les inconvénients de l'art antérieur précité, et de fournir un procédé simple, facile à mettre en œuvre et économique qui permette la fabrication d'une pièce métallique, céramique ou composite ou d'une microstructure métallique, céramique ou composite supportée, tout en garantissant un meilleur contrôle des états de surface et des textures, et en évitant la présence de discontinuités et/ou de porosité hétérogène au sein de ladite pièce ou microstructure.

Le procédé selon l'invention a également pour but de fournir une microstructure métallique, céramique ou composite supportée par un substrat, ladite microstructure présentant une bonne adhérence audit substrat et pouvant être utilisée dans des applications variées, par exemple en créant à la surface d'un verre un réseau conducteur de l'électricité sans affecter notablement sa transparence optique afin d'obtenir un dispositif conducteur électrique transparent.

Le procédé selon l'invention a également pour but de fournir une pièce 3D métallique, céramique ou composite qui présente une bonne tenue mécanique et peut être utilisée dans des applications variées, notamment comme micro-aimant, connecteur électrique, antenne, bobine, méta-matériau photonique, phononique, magnéto-photonique ou magnonique.

L'invention a donc pour objet un procédé de fabrication d'une pièce métallique, céramique ou composite métal-céramique ou d'une microstructure supportée métallique, céramique ou composite métal-céramique, caractérisé en ce qu'il comprend au moins les étapes suivantes :
i) le dépôt d'une suspension ou d'une poudre d'au moins un oxalate de métal, éventuellement en mélange avec un ou plusieurs composés issus de la décomposition partielle dudit oxalate de métal, sur au moins une partie d'une surface d'un substrat solide, afin de former une couche dudit oxalate de métal éventuellement en mélange avec le ou lesdits composés,
   étant entendu que :
   ^{∗} l'oxalate de métal répond à la formule (I) suivante :

      M₂(C₂O₄)ᵥ. n H₂O (I) dans laquelle :

      - M est un cation métallique au degré d'oxydation +v (i.e. M^{v+}) ou un mélange de cations métalliques de degré d'oxydation moyen +v,
      - v est un nombre entier tel que 1≤ v≤4,
      - n est tel que n ≥ 0, et de préférence 0≤ n ≤8, et
   ^{∗} l'oxalate de métal (I) (et le ou les composés issus de la décomposition partielle dudit oxalate de métal s'ils existent) de la suspension ou de la poudre est sous la forme de particules et/ou d'agglomérats de particules, de taille moyenne allant de 10 nm à 100 µm environ,
ii) l'échauffement local d'au moins une zone de la couche de l'étape i), à l'aide d'un faisceau laser fonctionnant à une longueur d'onde allant de 150 nm à 2000 nm environ, et de préférence de 150 nm à 1200 nm environ, et de préférence encore de 250 nm à 900 nm environ, à une densité de puissance suffisante pour transformer de façon irréversible la couche de la zone localement échauffée en une couche métallique, céramique ou composite métal-céramique présentant un motif correspondant à la zone échauffée,
iii) éventuellement l'élimination des zones non échauffées de la couche, et
iv) éventuellement la réitération, une ou plusieurs fois, de la séquence des étapes i) à ii) ou i) à iii), de manière à former une ou plusieurs nouvelle(s) couche(s) métallique(s),céramique(s) ou composite(s) métal-céramique sur au moins une partie d'une surface libre du substrat solide et/ou sur au moins une partie de la couche métallique, céramique ou composite métal-céramique précédente.

Ainsi, le procédé de l'invention est simple et économique. Il permet de conduire à une pièce ou une microstructure métallique, céramique ou composite métal-céramique à partir d'une suspension ou d'une poudre comprenant un oxalate de métal facile à préparer, tout en garantissant un meilleur contrôle des états de surface et des textures et en évitant la présence de discontinuités et/ou de porosité hétérogène au sein de ladite pièce ou microstructure.

### Etape i)

Le cation métallique M de l'oxalate de métal de formule (I) peut être choisi parmi Ag⁺, Li⁺, Cu²⁺, Fe²⁺, Ni²⁺, Mn²⁺, Co²⁺, Zn²⁺, Mg²⁺, Sr²⁺, Ba²⁺, Sn²⁺, Ca²⁺, Cd²⁺, Fe³⁺, Cr³⁺, Bi³⁺, Ce³⁺, Al³⁺, Sb³⁺, Ga³⁺, In³⁺, Y³⁺, La³⁺, Am³⁺, Zr⁴⁺, Hf⁴⁺ et U⁴⁺.

Les cations métalliques préférés sont les suivants : Ag⁺, Cu²⁺, Fe²⁺, Fe³⁺, Co²⁺, Ni²⁺,Bi³⁺, Sn²⁺.

Lorsque M est un mélange de cations métalliques au(x) degré(s) d'oxydation, identiques ou différents, +v, il peut être un mélange de m cations métalliques M₁,..., Mₘ₋₁, Mₘ, chacun ayant un degré d'oxydation +vᵢ, avec 1 ≤i≤ m, 2 ≤m≤7 et 1 ≤vᵢ≤ 4.

Les molécules d'eau si elles sont présentes, sont incluses dans la structure de l'oxalate de métal de formule (I).

Par ailleurs, l'oxalate de métal de formule (I) de la suspension ou de la poudre est stable à température ambiante.

Il en est de même pour le ou les composés issus de la décomposition partielle dudit oxalate de métal s'ils existent.

Le substrat solide peut être opaque ou transparent.

Le substrat solide peut être flexible ou rigide.

Le substrat solide peut être plan ou courbe.

Il peut en particulier être courbe lorsqu'il s'agit de former une microstructure supportée. Dans ce cas la courbure ne devra pas empêcher un dépôt homogène de la suspension d'oxalate de métal de formule (I) éventuellement en mélange avec un ou plusieurs composés issus de la décomposition partielle dudit oxalate de métal. La valeur acceptable de la courbure dépendra donc notamment des caractéristiques de viscosité et de mouillabilité de la suspension sur le substrat considéré.

Le substrat solide peut être en verre, en métal (e.g. silicium), en vitro-céramique, en céramique, en polymère, ou en n'importe quel matériau résistant et/ou inerte vis-à-vis de l'échauffement de l'étape ii) provoqué par le faisceau laser.

La taille du substrat solide utilisé dans le procédé de l'invention n'est pas limitative.

Grâce à l'utilisation d'au moins un oxalate de métal de formule (I), éventuellement en mélange avec un ou plusieurs composés issus de la décomposition partielle dudit oxalate de métal, sous la forme d'une suspension ou d'une poudre, la couche formée à l'étape i) est une couche continue et homogène, notamment sous la forme d'un film. Ce ou ces composés issus de la décomposition partielle dudit oxalate de métal de formule (I) peuvent être un ou plusieurs métaux M, alliés ou non, à l'état d'oxydation zéro et/ou un ou plusieurs oxydes de métaux M, M étant un ou plusieurs métaux des cations métalliques M^{v+} dudit oxalate.

Dans la présente invention, l'expression « décomposition partielle d'un oxalate de métal (I) » signifie une réaction au cours de laquelle l'oxalate de métal (I) est en partie transformé en un ou plusieurs métaux M, alliés ou non, à l'état d'oxydation zéro et/ou en un ou plusieurs oxydes desdits métaux M, M étant un ou plusieurs métaux des cations métalliques M^{v+} dudit oxalate, notamment par chauffage à une température d'au moins 100°C environ.

Lorsque le ou les composés issus de la décomposition partielle dudit oxalate de métal (I) sont présents dans la suspension ou la poudre, ils représentent au plus 75% en masse environ, et de préférence au plus 50% en masse environ, par rapport à la masse totale de l'oxalate de métal (I) et desdits composés.

La couche formée à l'étape i) présente de préférence une épaisseur allant de 1 à 700 µm environ, de préférence de 30 à 700 µm environ, et de préférence encore allant de 30 à 500 µm environ.

La couche de l'étape i) est une couche continue. En d'autres termes, elle ne présente pas des discontinuités de motifs et/ou irrégularités et/ou hétérogénéités de surface.

Selon un mode de réalisation particulier, la couche formée à l'étape i) présente une rugosité allant de 1 à 5 µm environ pour une surface d'analyse de 2.21 mm² environ.

La couche de l'étape i) est de préférence en contact physique direct avec le substrat solide ou une couche métallique, céramique ou composite précédemment formée lors d'une étape ii) lorsque l'étape iv) existe.

Ledit oxalate de métal de formule (I), et éventuellement le ou les composés provenant de la décomposition partielle dudit oxalate de métal de formule (I), représente(nt) de préférence au moins 80% en masse, et de préférence encore au moins 90% en masse environ, par rapport à la masse totale de la couche.

Selon une forme de réalisation particulièrement préférée de l'invention, la couche formée à l'étape i) comprend uniquement ledit oxalate de métal de formule (I) éventuellement en mélange avec un ou plusieurs composés provenant de la décomposition partielle dudit oxalate de métal de formule (I) (i.e. ledit oxalate de métal de formule (I), et éventuellement le ou les composés provenant de la décomposition partielle dudit oxalate de métal de formule (I) représente(nt) 100% en masse environ, par rapport à la masse totale de la couche).

Dans la présente invention, l'expression « suspension d'au moins un oxalate de métal de formule (I) éventuellement en mélange avec un ou plusieurs composés provenant de la décomposition partielle dudit oxalate de métal de formule (I) » signifie que l'oxalate de métal est en suspension dans un solvant liquide, c'est-à-dire sous la forme de particules solides et/ou d'agglomérats de particules solides dans ledit solvant liquide. L'oxalate de métal n'est donc pas dissous dans ledit solvant liquide.

En effet, comme expliqué auparavant, l'utilisation d'une solution d'un oxalate de métal (i.e. oxalate dissous dans un solvant liquide) ne permet pas de contrôler sa cristallisation lors du séchage, induisant la formation de grosses particules et/ou de particules de tailles hétérogènes néfastes pour la mise en œuvre de l'étape ultérieure ii).

Ainsi, lors de l'étape i), les particules et/ou d'agglomérats de particules d'oxalate de métal (I) de la poudre ou de la suspension ne subissent pas de modifications géométriques, morphologiques ou structurales (e.g. pas de changement de structure cristalline et/ou de dimensions) pour former la couche d'oxalate de métal.

La suspension peut être une suspension d'au moins un oxalate de métal de formule (I) éventuellement en mélange avec un ou plusieurs composés provenant de la décomposition partielle dudit oxalate de métal de formule (I), dans un solvant choisi parmi les polyols (e.g. éthylène glycol, propanediol, glycérol), les alcools simples (e.g. méthanol, éthanol, propanol), le tétrahydrofurane, le dodécane, l'eau et un mélange d'au moins deux des solvants précités s'ils sont miscibles.

Selon une forme de réalisation préférée, la suspension comprend de 20 à 80% en masse environ, et de préférence encore de 20 à 50% en masse environ, dudit oxalate de métal de formule (I), éventuellement en mélange avec un ou plusieurs composés provenant de la décomposition partielle dudit oxalate de métal de formule (I), par rapport à la masse totale de la suspension. Le reste de la suspension est généralement un solvant tel que défini précédemment.

Selon une forme de réalisation préférée de l'invention, la suspension peut comprendre en outre un ou plusieurs additifs inertes, dont la proportion varie avantageusement de 1 à 10% en masse environ, par rapport à la masse totale de la suspension.

De tels additifs inertes peuvent par exemple être des agents d'adhésion tels que de l'alcool polyvinylique ou de la polyvinylpyrrolidone.

Dans la présente invention, l'expression « additifs inertes » signifie que les additifs ne touchent pas au processus chimique de la transformation de l'oxalate de métal (I) mis en œuvre lors de l'étape ii).

Par exemple, les additifs inertes sont différents d'agents réducteurs ou oxydants, tels que ceux pouvant déclencher une réaction d'oxydoréduction d'oxalates de métaux en métal et/ou oxyde métallique.

Dans le procédé de la présente invention, c'est l'échauffement local tel que défini dans l'étape ii) qui permet de transformer directement la couche d'oxalate de métal en couche métallique, céramique ou composite métal-céramique.

En d'autres termes, aucun additif et/ou agent, tel qu'un agent initiateur, n'est nécessaire pour réaliser cette transformation de la couche d'oxalate de métal.

La suspension peut être préparée par mélange d'au moins un oxalate de métal de formule (I), éventuellement en présence d'un ou plusieurs composés provenant de la décomposition partielle dudit oxalate de métal de formule (I), et d'un solvant tel que défini précédemment.

Le mélange peut être effectué dans un mortier et/ou à l'aide d'ultrasons (e.g. en plaçant le mélange dans une cuve à ultrasons). Les ultrasons permettent d'améliorer la dispersion des particules d'oxalate de métal (I) dans le solvant.

La suspension a de préférence une viscosité allant de 30 à 300 cP environ, ladite viscosité étant mesurée à 25°C environ, à l'aide d'un viscosimètre rotationnel tel qu'un appareil vendu sous la dénomination commerciale Rhéomat 100 par la société Lamy Rheology.

Lorsqu'une suspension est utilisée, l'étape i) est de préférence réalisée en déposant la suspension de l'oxalate de métal de formule (I), éventuellement en mélange avec un ou plusieurs composés provenant de la décomposition partielle dudit oxalate de métal de formule (I), sur au moins une partie d'une surface du substrat solide, puis en séchant ladite suspension. Cela permet ainsi de former la couche de l'étape i).

Cette étape permet de garder le bénéfice de l'état de cristallisation de l'oxalate de métal de formule (I), celui-ci ayant été élaboré préalablement sous forme de poudre (cf. étape i₀) et de conserver une granulométrie homogène de l'oxalate de métal de formule (I) éventuellement en mélange avec un ou plusieurs composés provenant de la décomposition partielle dudit oxalate, au sein de la couche formée à l'étape i), induisant la formation d'une couche homogène et continue.

Le dépôt de la suspension sur le substrat solide peut être effectué par étalement centrifuge, aspersion ou trempage-retrait. Ces techniques sont bien connues de l'homme du métier, notamment sous les anglicismes suivants : « *spin coating* », « *spray coating* » ou « *deep coating* ».

A titre d'exemple, la suspension peut être déposée à l'aide d'un équipement d'enduction (dénommé parfois « tournette ») afin de former une couche sous la forme d'un film, ou à l'aide d'une pipette pour étaler des gouttes et réaliser un frottis.

Au terme de ce dépôt, la couche formée est séchée pour éviter l'évaporation brutale du solvant de la suspension lors de l'étape suivante ii).

Le séchage peut être réalisé par évaporation à température ambiante, par lyophilisation ou par chauffage à une température allant de 60 à 150°C environ. Le séchage dure généralement au moins 3 heures, afin d'éviter la fissuration du dépôt à l'état sec et/ou les fentes de retrait.

La lyophilisation est préférée.

Lorsqu'une suspension est utilisée, l'oxalate de métal (I), éventuellement en mélange avec un ou plusieurs composés provenant de la décomposition partielle dudit oxalate de métal de formule (I), est de préférence sous la forme de particules de taille moyenne allant de 10 nm à 5 µm environ, et de préférence de 100 nm à 1 µm environ.

Lorsqu'une suspension est utilisée, la couche formée à l'étape i) présente de préférence une épaisseur allant de 100 à 500 µm environ.

Lorsqu'une poudre est utilisée, l'étape i) est de préférence réalisée en déposant directement la poudre de l'oxalate de métal de formule (I), éventuellement en mélange avec un ou plusieurs composés provenant de la décomposition partielle dudit oxalate de métal de formule (I), sur au moins une partie d'une surface du substrat solide (e.g. manuellement ou à l'aide d'un système automatisé). Cela permet ainsi de former la couche de l'étape i) sous la forme d'un lit de poudre.

L'étape i) est de préférence réalisée par étalement de ladite poudre sur le substrat solide à l'aide d'un racloir, d'un couteau ou d'un rouleau ou par dépôt de ladite poudre coulant au travers d'une trémie.

Le dépôt à l'aide d'une trémie, d'un racloir ou d'un rouleau est préféré car il permet de favoriser un dépôt régulier et continu.

Lorsqu'une poudre est utilisée, l'oxalate de métal (I), éventuellement en mélange avec un ou plusieurs composés provenant de la décomposition partielle dudit oxalate de métal de formule (I), est de préférence sous la forme de particules et/ou d'agglomérats de particules, de taille moyenne allant de 1 à 100 µm environ, et de préférence encore de 3 à 20 µm environ.

Lorsqu'une poudre est utilisée, la couche formée à l'étape i) présente de préférence une épaisseur allant de 30 à 100 µm environ.

La suspension ou la poudre de l'étape i) peut comprendre plusieurs oxalates de métal de formule (I), éventuellement en mélange avec un ou plusieurs composés issus de la décomposition partielle desdits oxalates de métal (I).

### Etape i₀)

Le procédé peut comprendre en outre avant l'étape i), une étape i₀) de préparation d'au moins un oxalate de métal de formule (I) sous la forme de particules et/ou d'agglomérats de particules, de taille moyenne allant de 10 nm à 100 µm.

A l'issue de cette étape i₀), l'oxalate de métal peut être utilisé dans l'étape i) soit directement sous la forme d'une poudre, soit *via* la formation d'une suspension comme indiqué précédemment.

L'étape i₀) peut être effectuée par précipitation chimique, notamment en faisant réagir une solution d'au moins un sel de cation métallique M avec de l'acide oxalique ou un oxalate soluble dans ladite solution, M étant tel que défini pour la formule (I).

L'oxalate soluble dans la solution peut être l'oxalate d'ammonium ou l'oxalate de sodium.

Au cours de l'étape i₀), les cations métalliques M des sels utilisés sont précipités par les anions oxalate C₂O₄²⁻ pour former un oxalate de métal de formule (I).

Le sel de cation métallique M peut être un halogénure (e.g. chlorure ou bromure), un sulfate, un nitrate ou un acétate.

Les conditions de précipitation permettant de préparer des oxalates de métaux de tailles et de morphologies diverses, notamment ceux de l'invention, sont bien connues de l'homme du métier, et sont par exemple décrites dans Tailhades, Thèse, 1988, Université Paul Sabatier.

L'homme du métier sait comment adapter les conditions réactionnelles de l'étape i₀), afin de former un oxalate de métal ayant la granulométrie souhaitée (e.g. particules et/ou des agglomérats de taille moyenne allant de 10 nm à 100 µm environ, ou de 1 à 100 µm environ, ou de 3 à 20 µm, ou de 10 nm à 5 µm environ ou de 100 nm à 1 µm environ).

### Etape ii)

Lors de l'étape ii), l'échauffement provoqué par le faisceau laser conduit à la décomposition de l'oxalate de métal de formule (I) en une phase de type métallique ou oxyde, ou en un composite métal-oxyde. Cela permet ainsi de former une couche métallique, céramique ou composite métal-céramique dans la zone insolée ou échauffée. La décomposition se produisant à l'étape ii) est une transformation irréversible.

En particulier, suite à l'absorption d'une partie de l'énergie apportée par le faisceau laser, l'oxalate de métal se décompose pour conduire à la formation de nanoparticules très réactives dont la propension au frittage est grande puisque leur point de fusion est généralement abaissé par rapport à l'état massif.

Ainsi, au cours de l'étape ii), les cations métalliques M de la couche peuvent être soit réduits complètement pour former une phase métallique, soit portés partiellement ou complètement à un degré d'oxydation supérieur ou égal au degré d'oxydation +v du métal dans l'oxalate de métal de formule (I) pour former une phase oxyde (i.e. couche céramique), soit les deux pour former une couche composite métal-oxyde (i.e. métal-céramique).

La couche métallique, céramique ou composite formée à l'étape ii) peut donc être constituée d'un ou plusieurs métaux, d'un ou plusieurs alliages de métaux, d'un oxyde métallique simple ou mixte, ou d'un composite oxyde-métal.

L'étape ii) peut être effectuée à densité de puissance allant de 0,1.10⁶ à 10.10⁶ W/cm² environ, et de préférence de 0,1.10⁶ à 6.10⁶ W/cm² environ.

Ainsi, le procédé de l'invention est simple et économique compte tenu de la mise en œuvre de densités de puissance laser modérées.

Les inventeurs de la présente demande ont en effet découvert que la décomposition de l'oxalate de métal de la couche formée à l'étape i) peut être conduite sous un faisceau laser de faible densité de puissance (e.g. < 10⁷ W.cm⁻²), contrairement aux matériaux utilisés dans l'art antérieur qui nécessitent des densités de puissances élevées.

Typiquement, les machines de photolithogravure très largement utilisées dans le domaine de la microélectronique, peuvent être utilisées dans l'étape ii) du procédé de l'invention pour former des pièces ou microstructures métalliques, céramiques ou composites à partir d'une couche d'un oxalate de métal de formule (I) éventuellement en mélange avec un ou plusieurs composés provenant de la décomposition partielle dudit oxalate, même si les faisceaux laser qu'elles utilisent ne délivrent qu'une puissance de l'ordre de quelques dizaine de milliwatts, focalisée sur une surface voisine du micromètre.

Selon un mode de réalisation particulier du procédé de l'invention, l'étape ii) est réalisée en faisant défiler l'ensemble couche-substrat solide de l'étape i) par rapport au faisceau laser, à une vitesse dite « *de déplacement* » allant de 0,1 à 3000 mm.s⁻¹ environ.

Selon une forme de réalisation préférée, l'étape ii) est conduite en positionnant le point focal du faisceau laser à l'interface substrat solide-couche d'un oxalate de métal éventuellement en mélange avec un ou plusieurs composés provenant de la décomposition partielle dudit oxalate.

De préférence, l'étape ii) est réalisée avec un faisceau laser présentant un diamètre allant de 1 à 70 µm environ, de préférence de 1 à 20 µm, et de préférence encore de 1 à 10 µm.

La durée de l'étape ii) est définie par la vitesse de balayage du faisceau laser allant de préférence de 0,1 à 5000 mm/s et le diamètre du faisceau laser. Par exemple, pour un faisceau laser de 70 µm de diamètre et une vitesse de 2500 mm/s, le temps d'insolation est de 2,8.10⁻⁵ s.

L'étape ii) peut être par exemple effectuée à l'aide d'un appareil comprenant un laser à semi-conducteur (diode laser), un laser solide ou un laser à gaz, et de préférence un laser solide.

A titre d'exemples de lasers convenant dans la présente invention, on peut citer les diodes lasers, les lasers solides tels que les lasers Nd-YAG ou titane-saphir.

A titre d'exemple d'appareil pouvant être utilisé, on peut citer un appareil de lithographie conventionnel ou une machine de fabrication additive pouvant délivrer une densité de puissance allant de 0,1.10⁶ à 10.10⁶ W/cm² environ, notamment avec une diode laser émettant à 405 nm ou un laser solide Nd-YAG émettant à 1,07 µm.

Dans la présente invention, l'expression « échauffement à l'aide d'un faisceau laser » signifie également insolation laser.

Lors de l'étape ii), l'insolation laser suit un dessin (ou motif) préalablement programmé dans un système de contrôle de l'appareil laser utilisé. Ce dessin peut correspondre soit au premier plan de coupe de la pièce à réaliser, soit à la géométrie finale de motifs bi-dimensionnels de la microstructure à réaliser.

Le motif de la couche formée à l'étape ii) est variable et peut être notamment un quadrillage, un rectangle, un carré, une ligne droite, une ligne courbe ou toute autre forme désirée.

L'étape ii) est réalisée de préférence à pression atmosphérique.

L'étape ii) peut être effectuée à l'air, sous atmosphère inerte telle qu'une atmosphère d'azote, d'argon ou d'hélium, ou une atmosphère réductrice telle qu'un mélange d'argon ou d'azote avec du dihydrogène dans des proportions qui, de préférence, ne donneront pas une atmosphère dangereuse (e.g. ≤3,9 % en volume de dihydrogène).

Selon le type de métal utilisé pour l'oxalate de formule (I) (e.g. argent) et son épaisseur, la couche formée à l'étape ii) peut être peu absorbante vis-à-vis du faisceau laser.

L'étape ii) peut être effectuée plusieurs fois avant l'étape iii) ou après l'étape iii), notamment afin d'échauffer plusieurs fois la zone (ou au moins une partie de la zone) déjà insolée une première fois.

La réitération de l'étape ii) peut être effectuée avec une densité de puissance identique ou supérieure à celle de l'étape ii) précédente.

L'étape ii) peut également être effectuée selon la série suivante : une insolation laser de la zone selon un axe transversal (0,y), puis une insolation laser de la zone selon un axe longitudinal (0,x). Cette série peut être effectuée plusieurs fois, notamment avec une densité de puissance identique ou supérieure à celle de l'étape ii) précédente.

Lorsque l'étape ii) est effectuée plusieurs fois, la puissance du faisceau laser peut être progressivement augmentée après chaque insolation laser, ou après chaque série d'insolations laser ou après plusieurs (e.g. deux ou trois) séries d'insolations laser.

Lorsque l'étape ii) est effectuée plusieurs fois sur la même zone, cela permet d'améliorer la cohésion et/ou la tenue mécanique de la couche formée à l'étape ii). Ce mode de réalisation est particulièrement approprié lorsque l'on souhaite fabriquer une pièce métallique, céramique ou composite métal-céramique.

### Etape iii)

L'étape iii) peut être conduite par lavage, par dissolution ou par aspiration.

L'étape iii) permet ainsi d'éliminer l'oxalate de métal qui n'a pas été insolé au cours de l'étape ii), tout en garantissant que la couche métallique, céramique ou composite métal-céramique formée au cours de l'étape ii) ne soit pas endommagée.

Le lavage ou l'aspiration est particulièrement adapté lorsque l'étape i) est réalisée par dépôt d'un oxalate de métal de formule (I) éventuellement en mélange avec un ou plusieurs composés provenant de la décomposition partielle dudit oxalate, sous la forme d'une poudre.

Le lavage peut être effectué à l'aide d'ultrasons ou d'un flux de liquide inerte (e.g. jet d'eau).

La dissolution peut être effectuée à l'aide d'un agent de dissolution ou d'un fluide supercritique.

La dissolution est particulièrement adaptée lorsque l'étape i) est effectuée par dépôt d'un oxalate de métal de formule (I) sous la forme d'une suspension.

De préférence, l'agent de dissolution est choisi parmi une solution aqueuse d'ammoniaque ou une solution aqueuse d'acide fort (e.g. acide chlorhydrique, acide sulfurique), notamment à une concentration permettant de dissoudre le ou les oxalates sans attaquer fortement les oxydes de métaux et/ou les métaux formés dans les zones insolées.

La solution aqueuse d'ammoniaque peut avoir une concentration molaire en ammoniaque de 0,5 à 4 mol/l environ.

Le fluide supercritique peut être du CO₂ supercritique.

L'étape iii) peut également être effectuée en utilisant une couche sacrificielle.

La technique de la couche sacrificielle est bien connue de l'homme du métier, notamment dans le domaine de la microélectronique, et consiste en la dissolution sélective des couches dites sacrificielles en regard des couches structurales qui seront conservées après ladite dissolution.

Lorsque l'étape iv) existe, une ou plusieurs nouvelle(s) couche(s)métallique(s),céramique(s) ou composite(s) métal-céramique sont formées sur au moins une partie d'une surface libre du substrat solide (i.e. une partie d'une surface du substrat qui n'a pas été déjà recouverte par une couche lors d'une étape ii) précédente) et/ou sur au moins une partie de la couche métallique, céramique ou composite métal-céramique précédente.

L'étape iv) est réalisée à l'aide d'une poudre d'oxalate de métal de formule (I), éventuellement en mélange avec un ou plusieurs composés provenant de la décomposition partielle dudit oxalate de métal de formule (I), lorsque l'étape iv) consiste à former une ou plusieurs nouvelle(s) couche(s) métallique(s), céramique(s) ou composite(s) métal-céramique sur au moins une partie de la couche métallique, céramique ou composite métal-céramique précédente.

L'étape iv) est réalisée à l'aide d'une poudre ou d'une suspension d'oxalate de métal de formule (I), éventuellement en mélange avec un ou plusieurs composés provenant de la décomposition partielle dudit oxalate de métal de formule (I), lorsque l'étape iv) consiste à former une ou plusieurs nouvelle(s) couche(s) métallique(s), céramique(s) ou composite(s) métal-céramique sur au moins une partie d'une surface libre du substrat solide.

### Fabrication d'une microstructure supportée

Selon un premier mode de réalisation de l'invention, la couche métallique, céramique ou composite métal-céramique formée à l'étape ii), et les couches métalliques, céramiques ou composites métal-céramique formées à l'étape iv) si l'étape iv) existe, ne sont pas séparées du substrat solide et forment une microstructure supportée.

Le procédé conduit donc à la fabrication d'une microstructure métallique, céramique ou composite métal-céramique déposée sur un substrat solide (i.e. une microstructure supportée). La microstructure métallique, céramique ou composite métal-céramique est constituée de la couche métallique, céramique ou composite métal-céramique formée à l'étape ii) ou des couches métalliques, céramiques ou composites métal-céramique formées aux étapes ii) et iv).

L'étape iv) peut être effectuée au moins une fois pour former une nouvelle couche métallique, céramique ou composite métal-céramique présentant un motif correspondant à la zone échauffée sur une partie libre de la surface du substrat solide. Le motif formé à l'étape iv) peut être différent de celui de l'étape ii).

Selon une forme de réalisation particulièrement préférée de ce premier mode de réalisation, le substrat solide est un substrat transparent et le cation métallique de l'oxalate de métal (I) utilisé dans l'étape i) est un cation d'un métal conducteur, tel que l'argent ou le cuivre.

La microstructure formée à l'étape iii) ou iv) peut avoir une épaisseur allant de 1 µm à 200 µm environ.

### Fabrication d'une pièce

Selon un second mode de réalisation de l'invention, le procédé comprend l'étape iv) et les couches métalliques, céramiques ou composites métal-céramique formées aux étapes ii) et iv) forment une pièce qui est séparée du substrat solide selon une étape v) (pièce autosupportée).

Le procédé conduit donc à la fabrication d'une pièce métallique, céramique ou composite métal-céramique. La pièce métallique, céramique ou composite métal-céramique est constituée des couches métalliques, céramiques ou composites métal-céramique formées aux étapes ii) et iv).

En effet, pour réaliser une pièce tridimensionnelle, la mise en œuvre de l'étape iv) permet d'enchaîner une série de cycles consistant à déposer une couche d'oxalate de métal sur au moins une partie de son homologue préalablement insolée, puis à dessiner un nouveau plan de coupe par le faisceau laser sur cette couche additionnelle. Cette série de cycles est reproduite un nombre de fois suffisant pour construire dans son intégralité, la pièce souhaitée.

Les étapes iv) peuvent être effectuées en changeant la nature de l'oxalate de métal, de manière à former des couches de natures différentes.

L'étape v) peut être effectuée par découpage ou tronçonnage.

### Etape vi)

Le procédé peut comprendre en outre une étape vi) de traitement thermique de la pièce ou de la microstructure formée à l'étape ii, iii), iv) ou v).

Cette étape vi) permet d'améliorer le frittage.

L'étape vi) peut être effectuée à une température allant de 400 à 1500°C, et de préférence allant de 500 à 1000°C.

Selon une forme de réalisation préférée, l'étape vi) est réalisée à l'aide d'un four à éléments chauffants, notamment résistifs, d'un four à lampes, d'un four inductif ou d'un four micro-ondes.

Le procédé peut comprendre en outre après l'une quelconque des étapes ii), iii), iv) ou v), une étape vii) de traitement de sa surface.

Le procédé peut comprendre en outre après l'une quelconque des étapes ii), iii), iv) ou v), une étape viii) de dépôt d'un revêtement métallique ou céramique par un procédé électrochimique, d'électrophorèse, de dépôt chimique en phase vapeur, de dépôt sol-gel, etc....

Les étapes vi), vii) et viii) sont des étapes de finition, notamment mises en œuvre pour relaxer les contraintes mécaniques résiduelles, ajuster l'état d'oxydo-réduction, effectuer un changement de phase cristalline, améliorer les propriétés de surface (dureté, résistance à la corrosion, esthétique...) et/ou apporter toute autre fonctionnalité utile à l'application technologique de la pièce ou de la microstructure supportée.

Ainsi, le procédé de l'invention, qui a recours à des oxalates de métaux de formule (I) éventuellement en mélange avec un ou plusieurs composés provenant de la décomposition partielle desdits oxalates, permet d'abaisser significativement la puissance laser nécessaire à la fabrication desdites pièces ou microstructures supportées. Il permet de fabriquer des pièces ou microstructures supportées à base de métaux ou d'oxydes de métaux qui sont généralement difficiles à fritter ou à fondre par fabrication additive SLS ou SLM conventionnelle. Ainsi, le procédé peut utiliser des appareils dotés de lasers moins puissants, moins consommateurs d'énergie et moins onéreux.

Par ailleurs, le procédé de l'invention garantit un meilleur contrôle des états de surface et des textures, tout en évitant la présence de discontinuités et/ou de porosité hétérogène au sein de ladite pièce ou microstructure.

L'invention conduit donc à l'obtention d'une microstructure métallique, céramique ou composite supportée par un substrat solide, ladite microstructure comprenant au moins un métal M choisi parmi les métaux des cations métalliques M^{v+} tels que définis pour la formule (I).

En particulier, le métal M peut être choisi parmi Ag, Li, Cu, Fe, Ni, Mn, Co, Zn, Mg, Sr, Ba, Sn, Ca, Cd, Cr, Bi, Ce, Al, Sb, Ga, In, Y, La, Am, Zr, Hf et U, et de préférence parmi Ag, Cu, Fe, Co, Ni, Bi et Sn.

Le substrat solide peut être tel que défini dans le premier objet de l'invention.

L'invention conduit donc à l'obtention d'une pièce métallique, céramique ou composite comprenant au moins un métal M choisi parmi les métaux des cations métalliques M^{v+} tels que définis pour la formule (I).

En particulier, le métal M peut être choisi parmi Ag, Li, Cu, Fe, Ni, Mn, Co, Zn, Mg, Sr, Ba, Sn, Ca, Cd, Cr, Bi, Ce, Al, Sb, Ga, In, Y, La, Am, Zr, Hf et U, et de préférence parmi Ag, Cu, Fe, Co, Ni, Bi et Sn.

La décomposition brutale de l'oxalate de métal (I) sous l'effet d'un faisceau laser (étape ii)), suivi d'un refroidissement rapide, peut conduire à la formation d'alliages ou d'oxydes originaux, notamment de phases métastables. La métastabilité peut en effet résulter des conditions très éloignées de l'équilibre thermodynamique dans lesquelles elles sont formées. Par ailleurs le passage, lors de la décomposition de l'oxalate de métal (I), par la création de grains nanométriques peut engendrer des microstructures spécifiques (mésoporosité par exemple) dans la pièce ou la microstructure finale.

En particulier, la pièce ou la microstructure supportée obtenue par le procédé de l'invention présente une porosité micronique ou sub-micronique, distribuée de manière très homogène. La porosité peut être comprise entre 10 et 80 % en volume environ, la taille moyenne des pores pouvant être comprise entre 100 nm et 5 µm environ. Par ailleurs, la pièce ou la microstructure supportée peut comprendre des traces de carbone.

Les pièces et microstructures supportées obtenues par le procédé de l'invention sont par conséquent différentes de celles élaborées dans l'art antérieur à partir de poudres de métaux ou d'oxydes dont la composition et même la structure cristalline, sont identiques à celles du produit fini (matériau constitutif de la pièce ou microstructure finale). Elles peuvent en conséquence assurer des fonctionnalités différentes et répondre à des besoins technologiques non satisfaits actuellement.

Il est possible d'utiliser une microstructure supportée obtenue selon le procédé de l'invention comme matériau conducteur transparent, notamment dans les domaines de l'optique, du photovoltaïque ou de l'électronique transparente ; comme connecteur électrique ; comme méta-matériau à deux dimensions de type photonique, magnéto-photonique ou magnonique ; ou comme système microfluidique, notamment dans le domaine de la biologie ou du diagnostic.

Il est aussi possible d'utiliser une pièce obtenue selon le procédé de l'invention, comme antenne, bobine, micro-aimant, méta-matériau à bande interdite de type photonique, phononique, magnéto-photonique ou magnonique, ou comme pièce de forme complexe.

En particulier, la pièce peut être utilisée comme pièce de forme complexe nécessaire à la cohésion d'une structure (e.g. châssis, bride) ou exerçant une fonction mécanique (petites turbines, hélices).

La pièce ou la microstructure supportée peut également être utilisée dans le domaine des objets de luxe ou d'art décoratif ou de la bijouterie fantaisie.

### EXEMPLES

### Exemple 1 : fabrication d'une microstructure métallique à motifs périodiques selon le procédé conforme à l'invention

Un oxalate d'argent répondant à la formule Ag₂C₂O₄ et sous la forme d'une poudre de particules aciculaires de longueur moyenne de 5 µm environ et de largeur moyenne 1 µm a été préparé selon la procédure décrite dans K. Kiryukhina et al., Scripta Materialia, 2013, 68, 623-626.

1 g de cet oxalate a été mélangé à 4 g d'éthylène glycol dans un mortier en agate. Le mélange résultant a été ensuite placé dans une cuve à ultrasons pour assurer une bonne dispersion des particules dans l'éthylène glycol. La viscosité du mélange était de 32 cP environ et a été mesurée dans les conditions telles que définies dans la présente invention.

3 gouttes (environ 1,5 ml en volume) de la suspension obtenue précédemment ont été déposées sur une lame de verre de dimensions 3 cm × 2,5 cm à titre de substrat, afin de réaliser un frottis. L'ensemble a été placé dans un dispositif de lyophilisation vendu sous la dénomination commerciale Alpha2-4 par la société Christ pour permettre l'évaporation de l'éthylène glycol. Le compartiment du lyophilisateur renfermant l'échantillon a été amené de la pression atmosphérique jusqu'à 10⁻³ mbar environ en 3 heures environ, afin d'éviter la fissuration du dépôt à l'état sec. La température était de 25°C environ pendant toute l'opération. Après remise à la pression atmosphérique, la couche d'oxalate d'argent déposé sur la lame de verre avait une épaisseur d'environ 300 µm.

La lame de verre comportant la couche d'oxalate d'argent a ensuite été placée dans un dispositif de lithographie par laser vendu sous la dénomination commerciale Dilase 250 par la société KLOE. L'insolation laser a été effectuée en réglant la focalisation d'une diode laser de longueur d'onde 405 nm à l'interface lame de verre - couche d'oxalate d'argent. Le diamètre du faisceau laser était de 2 µm environ, la vitesse de déplacement de l'échantillon sous le faisceau laser était de 5 mm.s⁻¹ environ et la densité de puissance du laser était de 0,16.10⁶ W/cm² environ.

Le motif à insoler était une grille de 200 × 200 µm², et a été préalablement programmé sur le dispositif de lithographie.

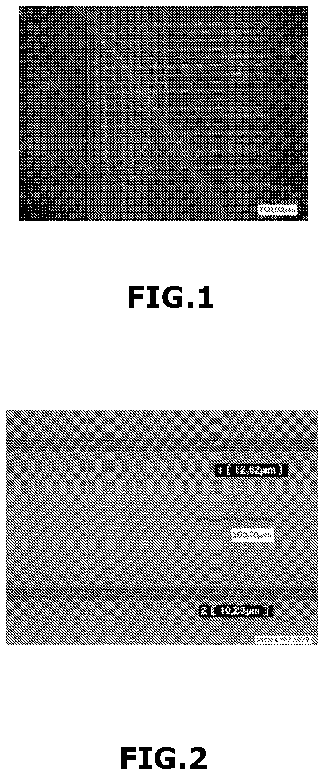

Ensuite, l'échantillon a été placé dans une solution aqueuse d'ammoniaque à 4 mol/l afin de dissoudre l'oxalate d'argent présent dans les zones qui n'ont pas été insolées. Seule subsiste sur la lame de verre, une grille d'argent métallique comprenant des fils d'argent de 12 µm environ de largeur et de 3 à 5 µm environ d'épaisseur. Lors de l'étape d'insolation laser, l'oxalate d'argent a en effet été réduit en argent métallique dans les zones insolées. La figure 1 montre une image de la microstructure supportée obtenue par le procédé de l'invention, ladite microstructure étant sous la forme d'une grille d'argent métallique.

La microstructure obtenue était transparente.

### Exemple 2 : fabrication d'une microstructure métallique à motifs périodiques selon le procédé conforme à l'invention

La microstructure obtenue selon l'exemple 1 a été chauffée jusqu'à une température de 300°C environ à une vitesse de chauffe de 150°C/h environ, à l'aide d'un four à éléments chauffants. La microstructure a été maintenue à 300°C pendant 1 h puis a été refroidie jusqu'à la température ambiante à une vitesse de refroidissement de 150°C/h environ. Cette étape supplémentaire a permis le frittage des fils d'argent tels qu'obtenus dans l'exemple 1. Une grille d'argent métallique comprenant des fils d'argent de 10µm environ de largeur et de 5 µm environ d'épaisseur a été ainsi obtenue.

La microstructure obtenue est restée transparente.

### Exemple 3 : fabrication d'une microstructure métallique à motif linéaire selon le procédé conforme à l'invention

Une microstructure a été préparée dans les mêmes conditions que celles décrites dans l'exemple 1, sauf en ce qui concernent la vitesse de déplacement de l'échantillon qui était de 1 mm/s au lieu de 5 mm/s et le motif à insoler qui était une ligne de longueur 15 mm au lieu d'une grille de 200 × 200 µm².

Par ailleurs, dix passages successifs ont été effectués suivant ledit motif sans étape iii) (i.e. sans élimination de la couche dans les zones non échauffées).

Une ligne d'argent métallique de largeur 15 µm environ et d'épaisseur voisine de 5 µm a ainsi été obtenue.

La conductivité électrique de cette ligne a été déterminée par la méthode des deux pointes en utilisant un multimètre de la marque Keithley, et était de 7,5.10⁵ S.m⁻¹ environ.

Ainsi, le procédé de l'invention permet de conférer une conductivité électrique à un substrat de verre tout en préservant sa transparence optique.

### Exemple 4 : fabrication d'une microstructure métallique à motif linéaire selon le procédé conforme à l'invention

Un oxalate de cuivre répondant à la formule CuC₂O₄.0,5H₂O et sous la forme d'une poudre de grains de 40 nm environ de longueur et de 25 nm environ de diamètre a été préparé selon la procédure décrite dans V. Baco-Carles et al., ISRN Nanotechnology, 2011, Article ID 729594, doi:10.5402/2011/729594, 7 pages).

1 g de cet oxalate a été mélangé à 4 g d'eau dans un mortier en agate. Le mélange résultant a été ensuite placé dans une cuve à ultrasons pour assurer une bonne dispersion des particules dans l'eau. La suspension résultante a été déposée sur un substrat de silicium sous la forme d'un film à l'aide d'un équipement d'enduction vendu sous la dénomination commerciale « spin coater » par la société SUSS et fonctionnant à une vitesse de rotation de 3000 tr/min environ. L'épaisseur du film obtenue était d'1 µm environ. Les équipements d'enduction (dénommé parfois « tournettes ») sont des équipements très courants commercialisés par différentes sociétés.

Le substrat comportant la couche d'oxalate de cuivre a ensuite été placé dans le dispositif de lithographie par laser tel que décrit dans l'exemple 1. L'insolation laser a été effectuée en réglant la focalisation d'un laser de longueur d'onde 405 nm à l'interface lame de verre - couche d'oxalate de cuivre. Le diamètre du faisceau laser était de 2 µm environ, la vitesse de déplacement de l'échantillon sous le faisceau laser était de 0,5 mm.s⁻¹ environ et la densité de puissance du laser était de 0,16.10⁶ W/cm² environ.

Le motif à insoler était des lignes de longueur 5 mm, et a été préalablement programmé sur le dispositif de lithographie.

Après l'étape d'insolation, des lignes de cuivre métallique partiellement oxydé en surface de 10 à 12 µm environ de largeur ont été formées sur le substrat. Lors de l'étape d'insolation laser, l'oxalate du cuivre a en effet été réduit en cuivre métallique partiellement oxydé en surface au contact de l'air dans les zones insolées. La figure 2 montre une image de la microstructure supportée obtenue par le procédé de l'invention, ladite microstructure étant sous la forme de lignes de cuivre métallique partiellement oxydé en surface.

### Exemple 5 : fabrication d'une microstructure métallique à motif linéaire selon le procédé conforme à l'invention

Un oxalate de cuivre sous la forme d'une poudre composée de particules isotropes de diamètre moyen de 3 µm environ a été préparé en modifiant les conditions de précipitation décrites dans V. Baco-Carles et al., ISRN Nanotechnology, 2011, Article ID 729594, doi:10.5402/2011/729594, 7 pages et dans Tailhades, Thèse, 1988, Université Paul Sabatier. On a fait alors précipiter une solution aqueuse de nitrate de cuivre Cu(NO₃)₂.2,5H₂O (98.5%, Alfa Aesar) de concentration 2M avec une solution aqueuse d'oxalate d'ammonium (NH₄)₂C₂O₄.H₂O, (98% Laurylab) de concentration 0,4M.

1 g de cet oxalate a été mélangé à 4 g d'éthylène glycol dans un mortier en agate. Le mélange résultant a été ensuite placé dans une cuve à ultrasons pour assurer une bonne dispersion des particules dans l'éthylène glycol.

La suspension a été déposée sur une lame de verre et séchée comme dans l'exemple 1.La lame de verre comportant la couche d'oxalate de cuivre a ensuite été placée dans le dispositif de lithographie par laser tel que décrit dans l'exemple 1. L'insolation laser a été effectuée en réglant la focalisation d'un laser de longueur d'onde 405 nm à l'interface lame de verre - couche d'oxalate de cuivre. Le diamètre du faisceau laser était de 2 µm environ de diamètre, la vitesse de déplacement de l'échantillon sous le faisceau laser était de 0,5 mm.s⁻¹ environ et la densité de puissance du laser était de 0,16.10⁶ W/cm² environ.

Le motif à insoler était une ligne de longueur 5 mm, et a été préalablement programmé sur le dispositif de lithographie.

Des lignes de cuivre métallique et/ou de cuivre réoxydé de 10 µm environ de largeur ont été formées.

### Exemple 6 : fabrication d'une microstructure céramique à motif rectangulaire selon le procédé conforme à l'invention

Un oxalate de fer répondant à la formule FeC₂O₄.2H₂O et sous la forme d'une poudre de particules aciculaires de longueur moyenne 0,5 µm et de 50 nm de largeur a été préparé selon la procédure décrite dans Tailhades, Thèse, 1988, Université Paul Sabatier.

1 g de cet oxalate de fer a été mélangé à 4 g d'éthylène glycol dans un mortier en agate. Le mélange résultant a été ensuite placé dans une cuve à ultrasons pour assurer une bonne dispersion des particules dans l'éthylène glycol.

La suspension a été déposée sur une lame de verre et séchée comme dans l'exemple 1. La lame de verre comportant la couche d'oxalate de fer a ensuite été placée dans le dispositif de lithographie par laser tel que décrit dans l'exemple 1. L'insolation laser a été effectuée en réglant la focalisation d'un laser de longueur d'onde 405 nm à l'interface lame de verre - couche d'oxalate de fer. Le diamètre du faisceau laser était de 2 µm environ, la vitesse de déplacement de l'échantillon sous le faisceau laser était de 1 mm.s⁻¹ environ et la densité de puissance du laser était de 0,41.10⁶ W/cm² environ.

Le motif à insoler était une zone rectangulaire de dimensions 18mm×15mm, et a été préalablement programmé sur le dispositif de lithographie.

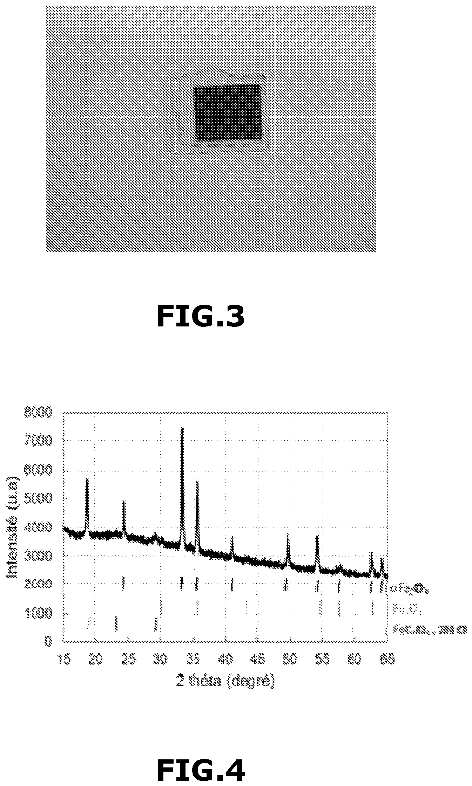

La couche insolée a été analysée par diffraction aux rayons X (DRX) à l'aide d'un appareil vendu sous la dénomination commerciale D4 par la société Brucker. La figure 3 montre une image de la microstructure supportée obtenue par le procédé de l'invention, ladite microstructure étant sous la forme d'une couche à base d'oxyde de fer.

L'analyse DRX a montré la présence d'une phase αFe₂O₃ majoritaire. Des traces de magnétite Fe₃O₄ et d'oxalate de fer ont également été observées comme le montre la figure 4.

### Exemple 7 : fabrication d'une microstructure céramique à motif selon le procédé conforme à l'invention

Un oxalate mixte de fer et de cobalt répondant à la formule CoFe₂(C₂O₄)₃ et sous la forme d'une poudre de particules aciculaires de longueur moyenne de 1 µm environ et de largeur moyenne 0,3 µm a été préparé selon la procédure décrite dans Le Trong H. et al., Solid State Sciences, 2008, 10(5), 550-556.

1 g de cet oxalate a été mélangé à 4 g d'éthylène glycol dans un mortier en agate. Le mélange résultant a été ensuite placé dans une cuve à ultrasons pour assurer une bonne dispersion des particules dans l'éthylène glycol.

La suspension a été déposée sur une lame de verre et séchée comme dans l'exemple 1. La lame de verre comportant la couche d'oxalate de fer et de cobalt a ensuite été placée dans le dispositif de lithographie par laser tel que décrit dans l'exemple 1. L'insolation laser a été effectuée en réglant la focalisation d'un laser de longueur d'onde 405 nm à l'interface lame de verre - couche d'oxalate de fer et de cobalt. Le diamètre du faisceau laser était de 2 µm de diamètre environ, la vitesse de déplacement de l'échantillon sous le faisceau laser était de 1 mm.s⁻¹ environ et la densité de puissance du laser était de 0,64.10⁶ W/cm² environ.

Le motif à insoler était un rectangle de dimension 18 × 15 mm², et a été préalablement programmé sur le dispositif de lithographie.

Une couche à motif rectangulaire dont la structure a été analysée par diffraction aux rayons X (DRX) à l'aide d'un appareil tel que décrit dans l'exemple 6 a été formée.

L'analyse DRX a montré la présence d'une phase spinelle. En effet, le diffractogramme est caractéristique d'une phase spinelle de type CoFe₂O₄ et d'une phase monoxyde de type CoO. Les mesures magnétiques réalisées avec un appareil VSM de modèle Versalab et de la marque Quantum Design ont montré la présence d'une phase ferrimagnétique. Le champ coercitif était de 1630 Oe à 300K. Après refroidissement sous un champ de 3 T de la température ambiante jusqu'à 100 K, le champ coercitif atteignait une valeur très élevée de 6130 Oe à 100 K. Le cycle d'hystérésis était décalé sur l'axe des abscisses (champ d'échange de 1650 Oe) révélant un couplage magnétique fort entre la phase spinelle et le monoxyde. Ce fort couplage témoigne aussi de la coexistence intime de ces phases à l'échelle nanométrique.

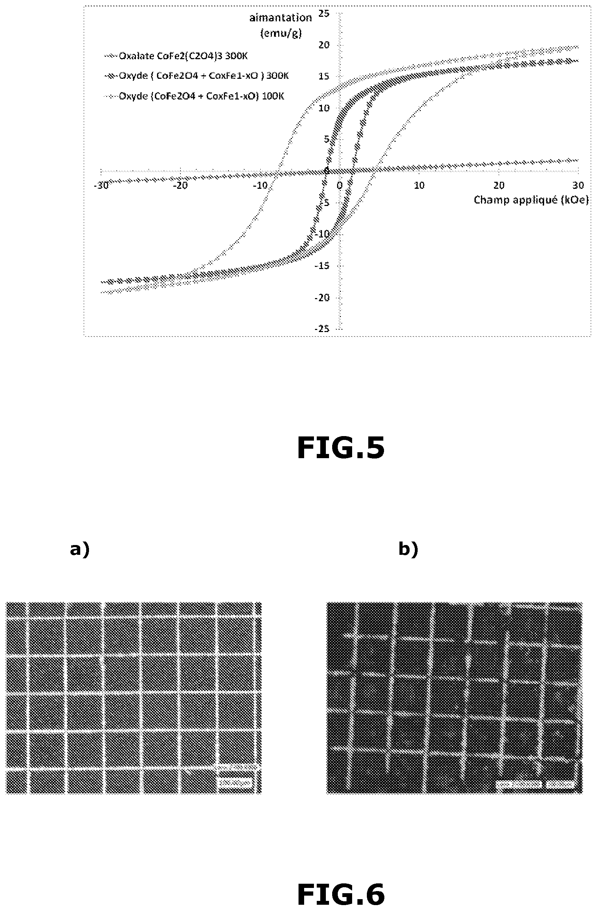

La figure 5 représente les courbes de l'aimantation M (en uem/g) de l'oxalate de formule (I) CoFe₂(C₂O₄)₃ à 300 K (courbe avec les losanges pleins) et des composés obtenus après insolation à 300 K (courbe avec les carrés pleins) et 100 K (courbe avec les triangles pleins), en fonction du champ magnétique H (en KOe).

### Exemple 8 : fabrication d'une pièce 3D selon le procédé conforme à l'invention

Une suspension d'oxalate d'argent dans de l'éthylène glycol a été préparée, déposée sur une lame de verre et séchée dans les conditions telles que décrites dans l'exemple 1. L'échantillon obtenu a ensuite été insolé en réglant la focalisation d'un laser de longueur d'onde 405 nm à l'interface lame de verre - couche d'oxalate d'argent. Le diamètre du faisceau laser était de 2 µm de diamètre environ et la vitesse de déplacement de l'échantillon sous le faisceau laser était de 1 mm.s⁻¹environ.

### Formation d'une première couche

Un premier motif formant un carré de dimensions 5 mm × 5 mm a été insolé sur toute sa surface à une densité de puissance de 0,16.10⁶ W/cm². L'insolation a été effectuée ligne par ligne selon un axe longitudinal (0,x).

Puis à l'intérieur de cette zone, un second carré de 3 mm × 3 mm a été insolé sur la totalité de sa surface, selon un axe transversal (0,y), à une densité de puissance de 0,22.10⁶ W/cm², puis selon un axe longitudinal (0,x), toujours à une densité de puissance de 0,22.10⁶ W/cm².

A ce stade, l'excédent de matière non insolé situé à l'extérieur de la zone traitée par le laser, a été enlevé.

L'échantillon a ensuite été replacé dans le dispositif de lithographie pour procéder à une insolation du second carré de 3 mm × 3 mm en augmentant progressivement la densité de puissance du laser (0,32.10⁶ W/cm², 0,64.10⁶ W/cm², 1,6.10⁶ W/cm², 2,7.10⁶ W/cm²) au terme de chaque série d'insolation effectuée alternativement selon l'axe (0,x) puis l'axe (0,y). Pour chaque puissance utilisée, 2 balayages ont été réalisés.

A l'issue de ces séquences d'insolations, on a obtenu un carré d'argent bien défini et qui présente une bonne adhérence au substrat de verre.

### Formation d'une deuxième couche

De la poudre d'oxalate d'argent tel qu'utilisé dans l'exemple 1 a ensuite été ajoutée et compactée à l'aide d'un racloir et de l'application d'une force manuelle sur le motif carré de 5 mm × 5 mm.

La poudre ainsi déposée a alors été insolée trois fois comme précédemment pour former un carré de 3 mm × 3 mm, en alternant toujours un balayage longitudinal (0,x) à une densité de puissance de 0,16.10⁶ W/cm² sur le carré de 5 mm× 5 mm, puis un balayage transversal (0,y) suivi d'un balayage longitudinal (0,x) à une densité de puissance de 0,22.10⁶ W/cm² sur le carré de 3 mm × 3 mm. La poudre non insolée a ensuite été enlevée.

L'échantillon a ensuite été replacé dans le dispositif de lithographie pour procéder à une insolation du second carré de 3 mm × 3 mm en augmentant progressivement la puissance du laser (0,32.10⁶ W/cm², 0,64.10⁶ W/cm², 1,6.10⁶ W/cm², 2,7.10⁶ W/cm² et 3,2.10⁶ W/cm²) au terme de chaque série d'insolation effectuée alternativement selon l'axe (0,x) puis l'axe (0,y). Pour chaque puissance utilisée, 4 balayages ont été réalisés.

### Formation d'une troisième couche puis d'une quatrième couche

Les opérations pour la deuxième couche ont été reproduites pour les troisième et quatrième couches. A l'issue de ces différentes étapes, un objet 3D d'épaisseur voisine de 600 µm environ a été obtenu. Cet objet était constitué d'argent métallique pur dont le frittage résultant de l'insolation par le faisceau laser, assure la tenue mécanique. L'analyse par diffraction des rayons X a confirmé l'obtention d'argent métallique.

### Exemple 9 : fabrication d'une microstructure métallique à motifs périodiques selon le procédé conforme à l'invention

L'oxalate d'argent utilisé dans l'exemple 1 a été partiellement décomposé en le chauffant pendant 20 heures environ à 120°C environ dans un four.

1 g de cet oxalate d'argent partiellement décomposé a été mélangé à 4 g d'éthylène glycol dans un mortier en agate. Le mélange résultant a été ensuite placé dans une cuve à ultrasons pour assurer une bonne dispersion des particules dans l'éthylène glycol.

La suspension a été déposée sur une lame de verre et séchée comme dans l'exemple 1.

La lame de verre comportant la couche d'oxalate d'argent partiellement décomposé a ensuite été placée dans le dispositif de lithographie par laser. L'insolation laser a été effectuée en réglant la focalisation d'un laser de longueur d'onde 405 nm à l'interface lame de verre - couche d'oxalate d'argent partiellement décomposé. Le diamètre du faisceau laser était de 2 µm environ, la vitesse de déplacement de l'échantillon sous le faisceau laser était de 1 mm.s⁻¹ environ et la densité de puissance du laser était de 0,22.10⁶ W/cm² environ.

Le motif à insoler était des lignes de 5 mm de longueur et a été préalablement programmé sur le dispositif de lithographie. Des lignes d'argent métallique de largeur moyenne 10 µm ont étaient obtenues.

### Exemple comparatif 10 : fabrication d'une microstructure métallique selon un procédé non conforme à l'invention

1 g de nitrate d'argent a été mélangé respectivement à 1 g (mélange A) et 4 g (mélange B) d'éthylène glycol dans un mortier en agate. Les mélanges résultants A et B étaient respectivement sous la forme d'une suspension A incolore et d'une solution B incolore (limite de solubilité du nitrate d'argent dans l'éthylène glycol : 49,67 g pour 100 g d'éthylène glycol à 20°C environ).

Les mélanges précités A et B ont été conservés à 5°C afin d'éviter un changement de coloration (de l'incolore au noir) au bout de quelques heures.

3 gouttes de la suspension A obtenue précédemment (respectivement 3 gouttes de la solution B obtenue précédemment) ont été déposées sur une lame de verre de dimensions 3 cm × 2,5 cm à titre de substrat, afin de réaliser un frottis. L'ensemble a été placé dans un dispositif de lyophilisation vendu sous la dénomination commerciale Alpha2-4 par la société Christ pour permettre l'évaporation de l'éthylène glycol. Le compartiment du lyophilisateur renfermant l'échantillon a été mis à l'abri de la lumière et amené de la pression atmosphérique jusqu'à 10⁻³ mbar environ en 3 heures environ. La température était de 25°C environ pendant toute l'opération. Après remise à la pression atmosphérique, les deux dépôts de nitrate d'argent déposés sur la lame de verre ne formaient pas une couche continue, et présentaient notamment des hétérogénéités de surface.

La lame de verre comportant le dépôt issu de la solution B (respectivement comportant le dépôt issu de la suspension A) a ensuite été placée dans un dispositif de lithographie par laser tel que décrit dans l'exemple 1. L'insolation laser a été effectuée en réglant la focalisation d'un laser de longueur d'onde 405 nm à l'interface lame de verre - dépôt de nitrate d'argent. Le diamètre du faisceau laser était de 2 µm environ, la vitesse de déplacement de l'échantillon sous le faisceau laser était de 0,5 mm.s⁻¹ environ et la densité de puissance du laser était de 0,9.10⁶ W/cm² environ.

Le motif à insoler était une grille de 200 × 200 µm² pour le dépôt issu de la solution B et celui issu de la suspension A, et a été préalablement programmé sur le dispositif de lithographie.

Ensuite, les échantillons ont été placés dans une solution aqueuse d'ammoniaque à 4 mol/l afin de dissoudre le nitrate d'argent présent dans les zones qui n'ont pas été insolées.

Pour le dépôt issu de la solution B, seule subsiste sur la lame de verre une grille d'argent métallique comprenant des fils d'argent de 9-15 µm environ de largeur. La figure 6 montre une image de la microstructure supportée obtenue par un procédé conforme à l'invention en remplaçant la solution B par une suspension d'un oxalate d'argent et obtenue selon les mêmes conditions d'insolation que celles décrites ci-dessus (figure 6a), et par comparaison une image de la microstructure supportée obtenue par un procédé non conforme à l'invention et tel que décrit ci-dessus (figure 6b). La microstructure de la figure 6b est sous la forme d'une grille d'argent métallique présentant de nombreuses hétérogénéités de surface et des discontinuités. Par ailleurs, des observations par microscopie optique ont montré avant traitement avec de l'ammoniaque la formation de motifs de dimensions irrégulières en raison de fortes hétérogénéités de surface observées, et de fortes hétérogénéités de transformation.

Pour le dépôt issu de la suspension A, le traitement avec de l'ammoniaque n'a pas permis de conserver la structure insolée. Par ailleurs, des observations par microscopie optique ont montré avant traitement avec de l'ammoniaque des motifs formés très mal définis en raison de fortes hétérogénéités de surface observées, et de fortes hétérogénéités de transformation.

### Exemple comparatif 11 : fabrication d'une microstructure métallique selon un procédé non conforme à l'invention

Une solution d'oxalate d'argent a été préparée en récupérant le surnageant d'une suspension préparée dans les mêmes conditions que celle décrite dans l'exemple 1 et décantée pendant 7 jours.

La concentration molaire en oxalate d'argent était extrêmement diluée, soit de 0,025 mol/l environ (i.e. une concentration massique de 0,7 %).

3 gouttes de la solution obtenue précédemment ont été déposées sur une lame de verre de dimensions 3 cm × 2,5 cm à titre de substrat, afin de réaliser un frottis. L'ensemble a été placé dans un dispositif de lyophilisation vendu sous la dénomination commerciale Alpha2-4 par la société Christ pour permettre l'évaporation de l'éthylène glycol. Le compartiment du lyophilisateur renfermant l'échantillon a été amené de la pression atmosphérique jusqu'à 10⁻³ mbar environ en 3 heures environ. La température était de 25°C environ pendant toute l'opération. Après remise à la pression atmosphérique, le dépôt d'oxalate d'argent déposé sur la lame de verre ne formait pas une couche continue en raison de la faible quantité d'oxalate d'argent déposé à partir de la solution.

La lame de verre comportant le dépôt issu de la solution d'oxalate a ensuite été placée dans un dispositif de lithographie par laser tel que décrit dans l'exemple 1. L'insolation laser a été effectuée en réglant la focalisation d'un laser de longueur d'onde 405 nm à l'interface lame de verre - dépôt de l'oxalate d'argent. Le diamètre du faisceau laser était de 2 µm environ, la vitesse de déplacement de l'échantillon sous le faisceau laser était de 1 mm.s⁻¹ environ et la densité de puissance du laser était de 0,9.10⁶ W/cm² environ.

Le motif à insoler était une ligne de 5 mm de longueur, et a été préalablement programmé sur le dispositif de lithographie.

Une ligne d'argent métallique de largeur maximale 10 µm a été obtenue.

Toutefois, la faible quantité de matière déposée en raison de l'utilisation d'une solution d'oxalate à la place d'une suspension d'oxalate n'a pas permis de former une ligne continue d'argent après insolation laser.

## Revendications

1. Procédé de fabrication d'une pièce métallique, céramique ou composite métal-céramique ou d'une microstructure supportée métallique, céramique ou composite métal-céramique, **caractérisé en ce qu'**il comprend au moins les étapes suivantes :
i) le dépôt d'une suspension ou d'une poudre d'au moins un oxalate de métal, éventuellement en mélange avec un ou plusieurs composés issus de la décomposition partielle dudit oxalate de métal, sur au moins une partie d'une surface d'un substrat solide, afin de former une couche dudit oxalate de métal éventuellement en mélange avec le ou lesdits composés,
étant entendu que :
^{∗} l'oxalate de métal répond à la formule (I) suivante :
M₂(C₂O₄)ᵥ. n H₂O (I)
dans laquelle :
- M est un cation métallique au degré d'oxydation +v ou un mélange de cations métalliques de degré d'oxydation moyen +v
- v est un nombre entier tel que 1 ≤ v ≤ 4,
- n est tel que n ≥ 0, et
^{∗} l'oxalate de métal de la suspension ou de la poudre est sous la forme de particules et/ou d'agglomérats de particules, de taille moyenne allant de 10 nm à 100 µm,
ii) l'échauffement local d'au moins une zone de la couche de l'étape i), à l'aide d'un faisceau laser fonctionnant à une longueur d'onde allant de 150 nm à 2000 nm, à une densité de puissance suffisante pour transformer de façon irréversible la couche de la zone localement échauffée en une couche métallique, céramique ou composite métal-céramique présentant un motif correspondant à la zone échauffée,
iii) éventuellement l'élimination des zones non échauffées de la couche, et
iv) éventuellement la réitération, une ou plusieurs fois, de la séquence des étapes i) à ii) ou i) à iii), de manière à former une ou plusieurs nouvelle(s) couche(s) métallique(s), céramique(s) ou composite(s) métal-céramique sur au moins une partie d'une surface libre du substrat solide et/ou sur au moins une partie de la couche métallique, céramique ou composite métal-céramique précédente.

2. Procédé selon la revendication 1, **caractérisé en ce que** le cation métallique M de l'oxalate de métal de formule (I) est choisi parmi Ag⁺, Li⁺, Cu²⁺, Fe²⁺, Ni²⁺, Mn²⁺, Co²⁺, Zn²⁺, Mg²⁺, Sr²⁺, Ba²⁺, Sn²⁺, Ca²⁺, Cd²⁺, Fe³⁺, Cr³⁺, Bi³⁺, Ce³⁺, Al³⁺, Sb³⁺,Ga³⁺, In³⁺, Y³⁺, La³⁺, Am³⁺, Zr⁴⁺, Hf⁴⁺ et U⁴⁺.

3. Procédé selon la revendication 1 ou 2,**caractérisé en ce que** le substrat solide est en verre, en métal, en vitro-céramique, en céramique, en matière plastique, ou en n'importe quel matériau résistant et/ou inerte vis-à-vis de l'échauffement de l'étape ii) provoqué par le faisceau laser.

4. Procédé selon l'une quelconque des revendications précédentes, **caractérisé en ce que** la couche formée à l'étape i) présente une épaisseur allant de 1 à 700 µm.

5. Procédé selon l'une quelconque des revendications précédentes, **caractérisé en ce que** ledit oxalate de métal de formule (I), et le ou les composés provenant de la décomposition partielle dudit oxalate de métal de formule (I), représente(nt) au moins 80% en masse, par rapport à la masse totale de la couche.

6. Procédé selon l'une quelconque des revendications précédentes, **caractérisé en ce que** la suspension a une viscosité allant de 30 à 300 cP, ladite viscosité étant mesurée à 25°C, à l'aide d'un viscosimètre rotationnel.

7. Procédé selon l'une quelconque des revendications précédentes, **caractérisé en ce que** la suspension est une suspension d'un oxalate de métal de formule (I) éventuellement en mélange avec un ou plusieurs composés issus de la décomposition partielle dudit oxalate de métal de formule (I) dans un solvant choisi parmi les polyols, les alcools simples, le tétrahydrofurane, le dodécane, l'eau et un mélange d'au moins deux des solvants précités s'ils sont miscibles.

8. Procédé selon l'une quelconque des revendications précédentes, **caractérisé en ce que** l'étape i) est réalisée en déposant la suspension de l'oxalate de métal de formule (I), éventuellement en mélange avec un ou plusieurs composés provenant de la décomposition partielle dudit oxalate de métal de formule (I), sur au moins une partie d'une surface du substrat solide, puis en séchant ladite suspension.

9. Procédé selon l'une quelconque des revendications 1 à 5, **caractérisé en ce que** l'étape i) est effectuée en déposant directement la poudre de l'oxalate de métal de formule (I), éventuellement en mélange avec un ou plusieurs composés provenant de la décomposition partielle dudit oxalate de métal de formule (I), sur au moins une partie d'une surface du substrat solide.

10. Procédé selon l'une quelconque des revendications précédentes, **caractérisé en ce que** l'étape ii) est effectuée à une densité de puissance allant de 0,1.10⁶ à 10.10⁶ W/cm².

11. Procédé selon l'une quelconque des revendications précédentes, **caractérisé en ce que** l'étape ii) est réalisée avec un faisceau laser présentant un diamètre allant de 1 à 70 µm.

12. Procédé selon l'une quelconque des revendications précédentes, **caractérisé en ce que** l'étape ii) est effectuée plusieurs fois avant ou après l'étape iii).

13. Procédé selon l'une quelconque des revendications précédentes, **caractérisé en ce que** la couche métallique, céramique ou composite métal-céramique formée à l'étape ii), et les couches métalliques, céramiques ou composites métal-céramique formées à l'étape iv) si l'étape iv) existe, ne sont pas séparées du substrat solide et forment une microstructure supportée.

14. Procédé selon la revendication 13, **caractérisé en ce que** le substrat solide est un substrat transparent et le cation métallique de l'oxalate de formule (I) utilisé dans l'étape i) est un cation d'un métal conducteur.

15. Procédé selon l'une quelconque des revendications 1 à 12, **caractérisé en ce qu'**il comprend l'étape iv) et les couches métalliques, céramiques ou composites métal-céramique formées aux étapes ii) et iv) forment une pièce qui est séparée du substrat solide selon une étape v).

## Patentansprüche

1. Verfahren zur Herstellung eines Bauteils aus Metall, Keramik oder Metall-Keramik-Verbundstoff oder einer durch Metall, Keramik oder Metall-Keramik-Verbundstoff geträgerten Mikrostruktur, **dadurch gekennzeichnet, dass** es mindestens die folgenden Schritte umfasst:
i) das Aufbringen einer Suspension oder eines Pulvers mindestens eines Metalloxalats, eventuell gemischt mit einer oder mehreren Verbindungen, die aus der teilweisen Zersetzung des Metalloxalats hervorgegangen sind, auf mindestens einen Teil einer Oberfläche eines festen Substrats, um eine Schicht des Metalloxalats eventuell gemischt mit der oder den Verbindungen zu bilden,
wobei davon auszugehen ist, dass:
* das Metalloxalat der folgenden Formel (I) entspricht:
M₂(C₂O₄)ᵥ. n H₂O (I)
wobei:
- M ein metallisches Kation mit dem Oxidationsgrad +V oder ein Gemisch metallischer Kationen mit einem mittleren Oxidationsgrad +V ist,
- v eine Ganzzahl wie 1≤ v≤ 4 ist,
- n derart ist, dass n > 0 ist, und
* das Metalloxalat der Suspension oder des Pulvers in Form von Partikeln und/oder Partikelagglomeraten mittlerer Größe von 10 nm bis 100 µm vorliegt,
ii) lokales Erwärmen von mindestens einer Zone der Schicht von Schritt i) mit Hilfe eines Laserstrahls, der mit einer Wellenlänge von 150 nm bis 2000 nm mit einer Leistungsdichte arbeitet, die ausreichend ist, um die Schicht der lokal erwärmten Zone irreversibel in eine Metall-, Keramik- oder Metall-Keramik-Verbundstoff-Schicht umzuwandeln, die ein Motiv aufweist, das der erwärmten Zone entspricht,
iii) eventuelles Entfernen der nicht erwärmten Zonen der Schicht, und
iv) eventuelles ein- oder mehrmaliges Wiederholen der Sequenz der Schritte i) bis ii) oder i) bis iii), so dass eine oder mehrere Metall-, Keramik- oder Metall-Verbund-Material-Schicht(en) auf auf mindestens einem Teil einer freien Oberfläche des festen Substrats und/oder auf mindestens einem Teil der vorhergehenden Metall-, Keramik- oder Metall-Verbund-Material-Schicht gebildet wird.

2. Verfahren nach Anspruch 1, **dadurch gekennzeichnet, dass** das metallische Kation M des Metalloxalats der Formel (I) aus Ag⁺, Li⁺, Cu²⁺, Fe²⁺, Ni²⁺, Mn²⁺, Co²⁺, Zn²⁺, Mg²⁺, Sr²⁺, Ba²⁺, Sn²⁺, Ca²⁺, Cd²⁺, Fe³⁺, Cr³⁺, Bi³⁺, Ce³⁺, Al³⁺, Sb³⁺, Ga³⁺, In³⁺, Y³⁺, La³⁺, Am³⁺, Zr⁴⁺, Hf⁴⁺ und U⁴⁺ ausgewählt ist.

3. Verfahren nach Anspruch 1 oder 2, **dadurch gekennzeichnet, dass** das feste Substrat aus Glas, aus Metall, aus Glaskeramik, aus Keramik, aus Kunststoff oder aus jedem beliebigen Material gebildet ist, das gegenüber der Erwärmung durch den Laserstrahl von Schritt ii) widerstandsfähig und/oder inert ist.

4. Verfahren nach einem der vorangehenden Ansprüche, **dadurch gekennzeichnet, dass** die in Schritt i) gebildete Schicht eine Dicke von 1 bis 700 µm aufweist.

5. Verfahren nach einem der vorangehenden Ansprüche, **dadurch gekennzeichnet, dass** das Metalloxalat der Formel (I) und die Verbindung(en) im Ergebnis der teilweisen Zersetzung des Metalloxalats der Formel (I) mindestens 80 Ma% im Verhältnis zur Gesamtmasse der Schicht darstellt/darstellen.

6. Verfahren nach einem der vorangehenden Ansprüche, **dadurch gekennzeichnet, dass** die Suspension eine Viskosität von 30 bis 300 cP hat, wobei die Viskosität bei 25 °C mit Hilfe eines Rotationsviskosimeters gemessen wird.

7. Verfahren nach einem der vorangehenden Ansprüche, **dadurch gekennzeichnet, dass** die Suspension eine Suspension eines Metalloxalats der Formel (I), eventuell gemischt mit einer oder mehreren Verbindungen im Ergebnis der teilweisen Zersetzung des Metalloxalats der Formel (I) in einem Lösungsmittel ist, das aus den Polyolen, den einfachen Alkoholen, Tetrahydrofuran, Dodecan, Wasser und einem Gemisch aus mindestens zwei der vorgenannten Lösungsmittel, wenn diese mischbar sind, ausgewählt ist.

8. Verfahren nach einem der vorangehenden Ansprüche, **dadurch gekennzeichnet, dass** der Schritt i) durch Aufbringen der Suspension des Metalloxalats der Formel (I), eventuell gemischt mit einer oder mehreren Verbindungen im Ergebnis der teilweisen Zersetzung des Metalloxalats der Formel (I), auf mindestens einen Teil einer Oberfläche des festen Substrats, dann durch Trocknen der Suspension, durchgeführt wird.

9. Verfahren nach einem der Ansprüche 1 bis 5, **dadurch gekennzeichnet, dass** der Schritt i) durch direktes Aufbringen des Pulvers des Metalloxalats der Formel (I), eventuell gemischt mit einer oder mehreren Verbindungen im Ergebnis der teilweisen Zersetzung des Metalloxalats der Formel (I), auf mindestens einen Teil einer Oberfläche des festen Substrats durchgeführt wird.

10. Verfahren nach einem der vorangehenden Ansprüche, **dadurch gekennzeichnet, dass** der Schritt ii) bei einer Leistungsdichte von 0,1.10⁶ bis 10.10⁶ W/cm² durchgeführt wird.

11. Verfahren nach einem der vorangehenden Ansprüche, **dadurch gekennzeichnet, dass** der Schritt ii) mit einem Laserstrahl durchgeführt wird, der einen Durchmesser von 1 bis 70 µm aufweist.

12. Verfahren nach einem der vorangehenden Ansprüche, **dadurch gekennzeichnet, dass** der Schritt ii) mehrmals vor oder nach dem Schritt iii) durchgeführt wird.

13. Verfahren nach einem der vorangehenden Ansprüche, **dadurch gekennzeichnet, dass** die in Schritt ii) gebildete Metall-, Keramik- oder Metall-Verbund-Material-Schicht und die in Schritt iv) gebildeten Metall-, Keramik- oder Metall-Verbund-Material-Schichten, wenn Schritt iv) vorhanden ist, nicht vom festen Substrat getrennt sind und eine geträgerte Mikrostruktur bilden.

14. Verfahren nach Anspruch 13, **dadurch gekennzeichnet, dass** das feste Substrat ein transparentes Substrat ist und das metallische Kation des Oxalats der Formel (I), das in Schritt i) verwendet wird, ein Kation eines leitenden Metalls ist.

15. Verfahren nach einem der Ansprüche 1 bis 12, **dadurch gekennzeichnet, dass** es den Schritt iv) umfasst und die in den Schritten ii) und iv) gebildeten Metall-, Keramik- oder Metall-Verbund-Material-Schichten ein Bauteil bilden, das gemäß einem Schritt v) vom festen Substrat getrennt ist.

## Claims

1. A method for manufacturing a part in metal, ceramic or metal-ceramic composite, or a supported microstructure in metal, ceramic or metal-ceramic composite, **characterized in that** it comprises at least the following steps:
i) depositing a suspension or a powder of at least one metal oxalate, optionally in a mixture with one or more compounds derived from partial decomposition of said metal oxalate, on at least part of a surface of a solid substrate, to form a layer of said metal oxalate optionally in a mixture with said compound(s),
on the understanding that:
∗ the metal oxalate meets following formula (I):
M₂(C₂O₄)ᵥ. n H₂O (I) where:
- M is a metal cation in oxidation state +v or a mixture of metal cations of mean oxidation state +v,
- v is an integer such that 1 ≤ v ≤ 4,
- n is such that n ≥ 0, and
∗ the metal oxalate of the suspension or powder is in the form of particles and/or agglomerates of particles of mean size ranging from 10 nm to 100 µm;
ii) locally heating at least one region of the layer of step i) by means of a laser beam operating at a wavelength ranging from 150 nm to 2000 nm, at sufficient power density for irreversibly converting the layer of the locally heated region to a metal, ceramic or metal-ceramic composite layer having a pattern corresponding to the heated region;
iii) optionally removing the non-heated regions from the layer; and
iv) optionally repeating the sequence of steps i) to ii) or i) to iii) one or more times to form one or more new metal, ceramic or metal-ceramic composite layers on at least part of a free surface of the solid substrate and/or on at least part of the preceding metal, ceramic or metal-ceramic composite layer.

2. The method according to claim 1, **characterized in that** the metal cation M of the metal oxalate of formula (I) is selected from among Ag⁺, Li⁺, Cu²⁺, Fe²⁺, Ni²⁺, Mn²⁺, Co²⁺, Zn²⁺, Mg²⁺, Sr²⁺, Ba²⁺, Sn²⁺, Ca²⁺, Cd²⁺, Fe³⁺, Cr³⁺, Bi³⁺, Ce³⁺, Al³⁺, Sb³⁺, Ga³⁺, In³⁺, Y³⁺, La³⁺, Am³⁺, Zr⁴⁺, Hf⁴⁺ and U⁴⁺.

3. The method according to claim 1 or 2, **characterized in that** the solid substrate is in glass, metal, vitro-ceramic, ceramic, plastic material or in a resistant and/or inert material against the heating of step ii) produced by laser beam.

4. The method according to any of the preceding claims, **characterized in that** the layer formed at step i) has a thickness ranging from 1 to 700 µm.

5. The method according to any of the preceding claims, **characterized in that** said metal oxalate of formula (I) and the compound(s) derived from partial decomposition of said metal oxalate of formula (I), represent at least 80 % by weight of the total weight of the layer.

6. The method according to any of the preceding claims, **characterized in that** the suspension has viscosity ranging from 30 to 300 cP, said viscosity being measured at 25 °C with a rotational viscosimeter.

7. The method according to any of the preceding claims, **characterized in that** the suspension is a suspension of a metal oxalate of formula (I), optionally in a mixture with one or more compounds derived from partial decomposition of said metal oxalate of formula (I), in a solvent selected from among polyols, simple alcohols, tetrahydrofuran, dodecane, water and a mixture of at least two of the aforementioned solvents if they are miscible.

8. The method according to any of the preceding claims, **characterized in that** step i) is conducted by depositing the suspension of metal oxalate of formula (I), optionally in a mixture with one or more compounds derived from partial decomposition of said metal oxalate of formula (I), on at least part of a surface of the solid substrate, then drying said suspension.

9. The method according to any of claims 1 to 5, **characterized in that** step i) is conducted by directly depositing the powder of metal oxalate of formula (I), optionally in a mixture with one or more compounds derived from partial decomposition of said metal oxalate of formula (I), on at least part of a surface of the solid substrate.

10. The method according to any of the preceding claims **characterized in that** step ii) is conducted at a power density ranging from 0.1×10⁶ to 10×10⁶ W/cm².

11. The method according to any of the preceding claims, **characterized in that** step ii) is conducted with a laser beam having a diameter ranging from 1 to 70 µm.

12. The method according to any of the preceding claims, **characterized in that** step ii) is conducted several times before or after step iii).

13. The method according to any of the preceding claims, **characterized in that** the metal, ceramic or metal-ceramic composite layer formed at step ii), and the metal, ceramic or metal-ceramic composite layers formed at step iv), if step iv) exists, are not separated from the solid substrate and form a supported microstructure.

14. The method according to claim 13, **characterized in that** the solid substrate is a transparent substrate and the metal cation of the formula (I) oxalate used at step i) is a cation of a conductive metal.

15. The method according to any of claims 1 to 12, **characterized in that** it comprises step iv), and the metal, ceramic or metal-ceramic composite layers formed at steps ii) and iv) form a part which is separated from the solid substrate at a step v).
